(19) Europäisches Patentamt / European Patent Office / Office européen des brevets

(11) **EP 4 059 634 B1**

(12) **EUROPEAN PATENT SPECIFICATION**

(45) Date of publication and mention
of the grant of the patent:
**16.04.2025  Bulletin 2025/16**

(21) Application number: **20901220.2**

(22) Date of filing: **18.12.2020**

(51) International Patent Classification (IPC):
**B22F 1/00** *(2022.01)*       **B22F 7/08** *(2006.01)*
**B22F 9/00** *(2006.01)*       **B82Y 30/00** *(2011.01)*
**B82Y 40/00** *(2011.01)*       **H01B 1/00** *(2006.01)*
**H01B 1/22** *(2006.01)*       **H01B 13/00** *(2006.01)*
**H01L 21/52** *(2006.01)*       **H05K 3/32** *(2006.01)*

(52) Cooperative Patent Classification (CPC):
(C-Sets available)
**H01B 1/22; B22F 1/052; B22F 1/054; B22F 1/107;
B22F 7/08; H01B 1/02; H01L 24/27; H01L 24/29;
H01L 24/83;** B22F 2998/10; B22F 2999/00;
H01L 24/05; H01L 2224/04026; H01L 2224/05644;
H01L 2224/2929;                                    (Cont.)

(86) International application number:
**PCT/JP2020/047489**

(87) International publication number:
**WO 2021/125336 (24.06.2021 Gazette 2021/25)**

(54) **SILVER PASTE AND METHOD FOR PRODUCING SAME, AND METHOD FOR PRODUCING JOINED ARTICLE**

SILBERPASTE, VERFAHREN ZU IHRER HERSTELLUNG UND VERFAHREN ZUR HERSTELLUNG EINES VERBUNDARTIKELS

PÂTE D'ARGENT ET SON PROCÉDÉ DE PRODUCTION ET PROCÉDÉ DE PRODUCTION D'ARTICLE SOUDÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **20.12.2019   JP 2019230645
09.12.2020   JP 2020204337**

(43) Date of publication of application:
**21.09.2022   Bulletin 2022/38**

(73) Proprietor: **Mitsubishi Materials Corporation
Tokyo 100-8117 (JP)**

(72) Inventors:
• **YASOSHIMA, Tsukasa**
  **Sanda-shi, Hyogo 669-1339 (JP)**
• **MASUYAMA, Kotaro**
  **Naka-shi, Ibaraki 311-0102 (JP)**
• **OTOGAWA, Kohei**
  **Sanda-shi, Hyogo 669-1339 (JP)**
• **KATASE, Takuma**
  **Sanda-shi, Hyogo 669-1339 (JP)**

(74) Representative: **Gille Hrabal
Partnerschaftsgesellschaft mbB
Patentanwälte
Brucknerstraße 20
40593 Düsseldorf (DE)**

(56) References cited:
WO-A1-2008/093913       WO-A1-2012/133767
WO-A1-2012/133767       WO-A1-2014/068299
WO-A1-2016/052033       CN-A- 108 102 579
CN-A- 108 417 292       JP-A- 2008 176 951
JP-A- 2008 198 595       US-A1- 2011 290 863

(52) Cooperative Patent Classification (CPC): (Cont.)
H01L 2224/29291; H01L 2224/29294;
H01L 2224/29339; H01L 2224/32227;
H01L 2224/32245; H01L 2224/83075;
H01L 2224/83192; H01L 2224/83447;
H01L 2224/83486; H01L 2224/8384;
H01L 2924/12041

C-Sets
B22F 2998/10, B22F 1/107, B22F 7/08,
B22F 3/1021, B22F 3/1039;
B22F 2999/00, B22F 7/08, B22F 7/064;
H01L 2224/05644, H01L 2924/00014;
H01L 2224/2929, H01L 2924/0635,
H01L 2924/00014;
H01L 2224/2929, H01L 2924/0665,
H01L 2924/00014;
H01L 2224/2929, H01L 2924/095, H01L 2924/066,
H01L 2924/0665, H01L 2924/00014;
H01L 2224/29291, H01L 2924/0715,
H01L 2924/00014;
H01L 2224/29291, H01L 2924/095,

H01L 2924/0675, H01L 2924/0715,
H01L 2924/00014;
H01L 2224/29339, H01L 2924/0103,
H01L 2924/01079, H01L 2924/00014;
H01L 2224/29339, H01L 2924/013,
H01L 2924/01029, H01L 2924/00014;
H01L 2224/29339, H01L 2924/013,
H01L 2924/01046, H01L 2924/00014;
H01L 2224/29339, H01L 2924/0132,
H01L 2924/01029;
H01L 2224/29339, H01L 2924/0132,
H01L 2924/01046;
H01L 2224/29339, H01L 2924/0132,
H01L 2924/01079;
H01L 2224/83075, H01L 2924/00012;
H01L 2224/83447, H01L 2924/00014;
H01L 2224/83447, H01L 2924/013,
H01L 2924/00014;
H01L 2224/83486, H01L 2924/0531,
H01L 2924/01029, H01L 2924/00014;
H01L 2224/83486, H01L 2924/0541,
H01L 2924/01029

**Description**

TECHNICAL FIELD

The present invention relates to a silver paste for bonding electronic components, a method for producing this silver paste, and a method for producing a bonded body using this silver paste.

BACKGROUND ART

Conventionally, for the purpose of adhering and fixing (die bonding) semiconductor elements such as high-power LED elements and power semiconductor elements, and electronic components such as semiconductor packages, to the surface of copper or copper alloy members, which are substrates such as Direct Bonded Copper substrates (copper-clad substrates) and lead frames, by using silver pastes, silver pastes including a silver powder, a thermosetting resin, and a solvent have been used.

Regarding this kind of silver paste, for example, a thermally conductive composition including a silver powder, fine silver particles, a fatty acid silver salt, an amine, and silver resinate is disclosed (see, for example, Patent Document 1). In this thermally conductive composition, the silver powder has an average particle size of 0.3 $\mu$m to 100 $\mu$m, the fine silver particles have an average particle size of primary particles of 50 to 150 nm, the crystallite diameter of the fine silver particles is 20 to 50 nm, and the ratio of the average particle size to the crystallite diameter is 1 to 7.5. This thermally conductive composition further contains an alcohol-based solvent such as methanol, ethylene glycol, and propylene glycol, for viscosity adjustment and the like. In Patent Document 1, it is described that a thermal conductor having a high thermal conductivity can be obtained using a thermally conductive composition configured as such.

Regarding another silver paste, an electroconductive paste is disclosed including fine silver particles having an average particle size of 1 to 200 nm and an organic solvent including a low-swelling organic solvent having a blanket swelling ratio of 2.0% or less, the electroconductive paste having a content percentage of the low-swelling organic solvent of 3.0 to 30 wt% (see, for example, Patent Document 2). Patent Document 2 describes that with regard to this electroconductive paste, it is preferable that an organic component be attached to at least a portion of the surface of the fine silver particles, and it is preferable that this organic component include an amine and a carboxylic acid from the viewpoints of dispersibility and electroconductivity of the fine silver particles. Furthermore, in Patent Document 2, it is described that the low-swelling organic solvent having a blanket swelling ratio of 2.0% or less is preferably a solvent having a hydroxyl group as a functional group, while the low-swelling organic solvent may be, for example, a polyhydric alcohol having a plurality of hydroxyl groups or another monohydric alcohol solvent, and that examples of the polyhydric alcohol having 2 or 3 hydroxyl groups include glycerin, 1,2,4-butanetriol, 1,2,6-hexanetriol, ethylene glycol, diethylene glycol, 1,2-butanediol, propylene glycol, and 2-methylpentane-2,4-diol. It is described in Patent Document 2 that this electroconductive paste can form a fine electroconductive pattern having sufficient electroconductivity and satisfactory adhesiveness to a substrate.

[Citation List]

[Patent Documents]

[Patent Document 1]
Japanese Patent No. 5872545 (Claim 1, paragraph [0006], and paragraph [0051]) corresponding to WO 2012/133767 A1
[Patent Document 2]
Japanese Patent No. 6329703 (Claim 1, paragraph [0010], paragraph [0034], paragraph [0035], paragraph [0052], paragraph [0055], and paragraph [0056])

SUMMARY OF INVENTION

Technical Problem

The surface of a DBC substrate (copper-clad substrate) and a copper or copper alloy member such as a lead frame, on which a silver paste layer is applied, is likely to have an oxide coating film of $CuO$ or $CuO_2$ formed thereon. Therefore, a metallized layer such as silver plating or nickel plating is formed on the surface of a copper or copper alloy member, a silver paste is applied on the metallized layer, and electronic components such as chip elements are bonded.

However, when an electronic component such as a chip element was bonded using the silver pastes shown in Patent Documents 1 and 2 without forming a metallized layer, it was difficult to bond the electronic component to the copper or copper alloy member with high strength. Therefore, there has been a demand for a silver paste capable of forming a silver paste layer directly on the surface of a copper or copper alloy member without providing a metallized layer and bonding an electronic component with high strength.

An object of the present invention is to provide a silver paste that forms a bonding layer directly on a surface of a copper or copper alloy member having no metallized layer such as silver plating or nickel plating and bonds an electronic component thereto with high strength, a method for producing the silver paste, and a method for producing a bonded body.

Solution to Problem

A first aspect of the present invention is a silver paste, including:

a silver powder;
a fatty acid silver salt;
an aliphatic amine;
a high-dielectric-constant alcohol having a dielectric constant of 34 or more and 44 or less; and
a solvent having a dielectric constant of less than 30, wherein the dielectric constant is a value measured at 22°C using a dielectric constant meter for liquids.

A second aspect of the present invention is an invention based on the first aspect and is a silver paste in which the high-dielectric-constant alcohol is included in the silver paste at a proportion of 0.01% by mass to 5% by mass when an amount of the silver paste is taken as 100% by mass.

A third aspect of the present invention is an invention based on the first or second aspect and is a silver paste in which the silver powder comprises: first silver particles having a particle size of 100 nm or more and less than 500 nm in a range of 55% by volume or more and 95% by volume or less; second silver particles having a particle size of 50 nm or more and less than 100 nm in a range of 5% by volume or more and 40% by volume or less; and third silver particles having a particle size of less than 50 nm in a range of 5% by volume or less.

A fourth aspect of the present invention is a method for producing a silver paste, the method comprising the steps of:

mixing a fatty acid silver salt, an aliphatic amine, and a solvent having a dielectric constant of less than 30 to obtain a mixture;
obtaining a mixed solution by cooling the mixture that is stirred while being heated; and
kneading the mixed solution, a silver powder, and a high-dielectric-constant alcohol having a dielectric constant of 30 or more to obtain a silver paste,
wherein the dielectric constant is a value measured at 22°C using a dielectric constant meter for liquids.

A fifth aspect of the present invention is a method for producing a bonded body, the method comprising the steps of:

forming a silver paste layer by applying the silver paste according to any one of the first to third aspects directly on a surface of a copper or copper alloy member;
producing a laminated body by laminating an electronic component on the silver paste layer; and
producing a bonded body, in which the copper or copper alloy member is bonded to the electronic component through a bonding layer, by forming the bonding layer by sintering the silver powder in the silver paste by heating the laminated body.

Advantageous Effects of Invention

The silver paste according to the first aspect of the present invention includes a silver powder, a fatty acid silver salt, an aliphatic amine; a high-dielectric-constant alcohol having a dielectric constant of 34 or more and 44 or less, and a solvent having a dielectric constant of less than 30. When this silver paste is applied directly on the surface of a copper or copper alloy member, the high-dielectric-constant alcohol having a dielectric constant of 34 or more and 44 or less reacts with an oxide film present on the surface of the copper or copper alloy member upon heating, and due to that reducing action, an oxide film of CuO and the like is removed from the surface of the copper or copper alloy member. The high-dielectric-constant alcohol having a dielectric constant of 34 or more and 44 or less easily approaches a silver ion in the complex formed by a reaction between the fatty acid silver salt and the aliphatic amine included in the silver paste. When the silver paste layer formed by this silver paste is heated, a reduction reaction of the complex occurs more smoothly by this high-dielectric-constant alcohol. When the silver in the complex is reduced, silver nanoparticles are formed, and these silver nanoparticles enhance the sinterability of the silver powder. As a result, even for a copper or copper alloy member having no metallized layer, it is possible to bond an electronic component to the surface of this copper or copper alloy member with high strength. The phrase "applied directly on the surface of a copper or copper alloy member" implies that a silver paste is applied on the surface of a copper or copper alloy member which does not have a metallized layer of silver, nickel, gold, or the like formed on the surface of the copper or copper alloy member.

With regard to the silver paste according to the second aspect of the present invention, the content of the high-dielectric-constant alcohol in the silver paste is in a proportion of 0.01% by mass to 5% by mass. The high-dielectric-constant alcohol within this range provides an effect of further producing silver nanoparticles from the silver complex in the silver paste layer when the silver paste layer is heated. On the other hand, the viscosity of the silver paste is not increased more than necessary, the handleability of the silver paste is not deteriorated, and the pot life (available time) of the silver paste is not shortened.

In the silver paste according to the third aspect of the present invention, since the silver powder includes first silver particles having a particle size of 100 nm or more and less than 500 nm in the range of 55% by volume or more and 95% by volume or less, includes second silver particles having a particle size of 50 nm or more and less than 100 nm in the range of 5% by volume or more and 40% by volume or less, and includes third silver particles having a particle size of less than 50 nm in the range of 5% by volume or less, as the silver powder has a relatively broad particle size distribution, the gaps between the first, second, and third silver particles become small and dense during sintering, so that a bonding layer with fewer voids can be produced.

In the method for producing a silver paste according to the fourth aspect of the present invention, since a high-dielectric-constant alcohol having a dielectric constant of 30 or more is mixed, after a mixed solution is prepared, with a silver powder together with the mixed solution, the handleability of the silver paste is not deteriorated, and the pot life (available time) of the silver paste is not shortened. In the mixed liquid, at least a portion of the fatty acid silver salt reacts with at least a portion of the aliphatic amine to form a complex. When a silver paste layer obtained by applying the silver paste on a copper or copper alloy member is heated, the high-dielectric-constant alcohol reduces the silver in the complex to produce silver nanoparticles, and these silver nanoparticles enhance the sinterability of the silver powder.

In the method for producing a bonded body according to the fifth aspect of the present invention, first, the silver paste according to any one of the first to third aspects is applied directly on the surface of a copper or copper alloy member to form a silver paste layer. Next, an electronic component is laminated on the copper or copper alloy member, with the silver paste layer interposed therebetween, to produce a laminated body, and this laminated body is heated. When the silver paste is heated, an oxide film of CuO and the like on the surface of the copper or copper alloy member is removed by the reducing action of the high-dielectric-constant alcohol included in the silver paste. As a result of this heating, the silver of the complex formed by a reaction of the fatty acid silver salt and the aliphatic amine in the silver paste is reduced by the high-dielectric-constant alcohol to form silver nanoparticles. These silver nanoparticles promote sintering of the silver powder to form a bonding layer, and the electronic component is bonded to the copper or copper alloy member with high strength, with this bonding layer interposed therebetween.

DESCRIPTION OF EMBODIMENTS

Next, embodiments for carrying out the present invention will be described. The silver paste includes a silver powder, a fatty acid silver salt, an aliphatic amine, a high-dielectric-constant alcohol having a dielectric constant of 34 or more and 44 or less, and a solvent having a dielectric constant of less than 30. Hereinafter, each component will be described in detail.

[Silver powder]

The silver powder of the present embodiment is not particularly limited, and a commercially available silver powder can be used. It is preferable that the silver powder include first silver particles (first group of silver particles), second silver particles (second group of silver particles), and third silver particles (third group of silver particles), whose particle sizes are different from each other. All of these first, second, and third silver particles aggregate with each other as primary particles to form aggregates (silver powder). It is preferable that the first silver particles have a particle size of 100 nm or more and less than 500 nm, and when the total amount of the first, second, and third silver particles is taken as 100% by volume, it is preferable that the amount of the first silver particles included be in the range of 55% by volume or more and 95% by volume or less. It is preferable that the second silver particles have a particle size of 50 nm or more and less than 100 nm, and when the total amount of the first, second, and third silver particles is taken as 100% by volume, it is preferable that the amount of the second silver particles included be in the range of 5% by volume or more and 40% by volume or less. It is preferable that the third silver particles have a particle size of less than 50 nm, and when the total amount of the first, second, and third silver particles is taken as 100% by volume, it is preferable that the amount of the third silver particles included be in the range of 5% by volume or less. The term "volume" as used herein indicates the volume of the silver particles themselves. The content proportions of the first, second, and third silver particles are each limited to the above-described ranges because when the silver powder has a relatively broad particle size distribution, dense aggregates with small gaps between the first, second, and third silver particles are formed at the time of sintering, and thereby a bonding layer having fewer voids is likely to be produced. The purity of silver in the first, second, and third silver particles is preferably 90% by mass or higher, and more preferably 99% by mass or higher. This is because the first, second, and third silver particles having higher silver purity melt more easily, and therefore, the first, second, and third silver particles can be sintered at a relatively low temperature. Regarding elements other than silver in the first, second, and third silver particles, Au, Cu, Pd, and the like may be included.

It is preferable that the first silver particles having a particle size of 100 nm or more and less than 500 nm be included in the range of 70% by volume or more and 90% by volume or less, it is preferable that the second silver particles having a particle size of 50 nm or more and less than 100 nm be included in the range of 10% by volume or more and 30% by volume or less, and it is preferable that the third silver particles having a particle size of less than 50 nm be included in the range of 1% by volume or less. When the particle size distributions of the first, second, and third silver particles are within the above-described ranges, the effect that dense aggregates having small gaps between the first, second, and third silver particles during sintering can be formed is enhanced, and a bonding layer with even fewer voids is likely to be produced. The particle sizes of the first, second, and third silver particles can be obtained by, for example, measuring projected areas of the first, second, and third silver particles in the silver powder by using a SEM (Scanning Electron Microscope: scanning microscopic photograph), calculating the equivalent circle diameters (diameters of circles having the same areas as the projected areas of the first, second, and third silver particles) from the obtained projected areas, and converting these calculated particle sizes into particle sizes on a volume basis. A specific example of the measuring method will be described in Examples that will be described later. It is preferable that any silver particles not corresponding to the first silver particles, the second silver particles, and the third silver particles be limited to 5% by volume or less when the total amount of the silver powder is taken as 100% by volume.

It is preferable that the silver powder include an organic material composed of an organic reducing agent or a decomposition product thereof, and it is preferable that this organic material be decomposed or volatilized at a temperature of 150°C. Examples of the organic reducing agent include ascorbic acid, formic acid, and tartaric acid. The organic material composed of an organic reducing agent or a decomposition product thereof suppresses oxidation of the surfaces of the first, second, and third silver particles when the first, second, and third silver particles are stored in a state of aggregated secondary particles (that is, silver powder before being made into a silver paste), and it is made easy to suppress mutual diffusion, that is, diffusion bonding during storage, of the first, second, and third silver particles. The organic material has an effect of being easily decomposed or volatilized when a silver paste including aggregates of silver particles is printed on a surface to be bonded of a member as an object of bonding and heated, thus exposing highly active surfaces of the first, second, and third silver particles easier to proceed. A decomposition product or volatile matter of the organic material has a reducing ability of reducing an oxide film on the surfaces to be bonded of a member as an object of bonding. When the organic material included in the silver powder remains in the bonding layer, there is a risk that the organic material may be decomposed over time, causing voids to be generated in the bonding layer. Therefore, it is preferable that the content proportion of the organic material be set to 2% by mass or less when the total amount of the first, second, third silver particles is taken as 100% by mass. However, in order to obtain the above-described effects brought by the organic material, it is preferable that the content proportion of the organic material be 0.05% by mass or more when the total amount of the first, second, and third silver particles is taken as 100% by mass. The content proportion of the organic material is more preferably 0.1% by mass to 1.5% by mass when the total amount of the first, second, and third silver particles is taken as 100% by mass.

[Fatty acid silver salt]

Examples of the fatty acid silver salt of the present embodiment include silver acetate, silver oxalate, silver propionate, silver myristate, and silver butyrate.

[Aliphatic amine]

Examples of the aliphatic amine of the present embodiment include a primary amine, a secondary amine, and a tertiary amine. It is desirable that the carbon number of the aliphatic be is preferably set to 8 to 12. When the carbon number is too small, the boiling point of the aliphatic amine tends to be low, and therefore, there is a risk that the printability of the silver paste may be deteriorated. When the carbon number is too large, sintering of the silver particles in the silver paste may be hindered, and there is a risk that a bonded body having sufficient strength may not be obtained. Specific examples include, as the primary amine, ethylhexylamine, aminodecane, dodecylamine, nonylamine, hexylamine, and octylamine;

as the secondary amine, dimethylamine, diethylamine, and dioctylamine; and as the tertiary amine, trimethylamine and triethylamine.

With regard to the silver paste, it is preferable that the molar ratio of the aliphatic amine to the fatty acid silver salt, that is, the ratio of the molar amount of the aliphatic amine/molar amount of the fatty acid silver salt, be within the range of 1.5 to 3. When the proportion of the aliphatic amine is small, the proportion of the fatty acid silver salt, which is a solid, is likely to be relatively high, and therefore, uniform dispersion in the silver paste is less likely to occur, and there is a risk that voids may be easily produced inside the bonding layer obtained by heating. When the proportion of the aliphatic amine is too large, an excess amount of the aliphatic amine is likely to cause grain growth of the silver powder in the silver paste, and since the paste viscosity is likely to be decreased, there is a risk that the printability may be deteriorated. The ratio of the molar amount of the aliphatic amine/molar amount of the fatty acid silver salt is more preferably within the range of 1.7 to 2.8, and even more preferably within the range of 2.0 to 2.5.

Since the silver paste includes a fatty acid silver salt and an aliphatic amine, at least a portion of this fatty acid silver salt reacts with at least a portion of the aliphatic amine to form a complex. This complex is presumed to be a silver-amine complex.

(High-dielectric-constant alcohol having dielectric constant of 34 or more and 44 or less)

Examples of high-dielectric-constant alcohol having a dielectric constant of 34 or more and 44 or less (hereinafter, simply referred to as high-dielectric-constant alcohol) include diethylene glycol (dielectric constant: 34), 1,3-propanediol (dielectric constant: 36), 1,2,4-butanetriol (dielectric constant: 38), and glycerin (dielectric constant: 44). These high-dielectric-constant alcohols may be used singly, or two or more kinds thereof may be used as mixtures. The above-mentioned dielectric constant is a value measured at 22°C using a dielectric constant meter for liquids (liquid dielectric constant meter Model-871 manufactured by Nihon Rufuto Co., Ltd.). . The dielectric constant of the high-dielectric-constant alcohol is 34 or more and 44 or less.

[Solvent]

The solvent of the present embodiment is a solvent having a dielectric constant of less than 30. Regarding this solvent, for example, a monohydric alcohol, a dihydric alcohol, an acetate-based solvent, and a hydrocarbon-based solvent are used. These may be used singly or in combination of two or more kinds thereof.

Examples of the monohydric alcohol include methanol, ethanol, 1-propanol, 2-propanol, 1-butanol, 2-butanol, 2-methyl-1-propanol, and 2-methyl-2-propanol, as well as a saturated aliphatic monohydric alcohol, an unsaturated aliphatic alcohol, an alicyclic alcohol, and an aromatic alcohol.

Examples of the saturated aliphatic monohydric alcohol include linear and branched alcohols such as natural alcohols and synthetic alcohols (for example, a Ziegler alcohol or an oxo alcohol), and specific examples thereof include 2-ethylbutanol, 2-methylpentanol, 4-methylpentanol, 1-hexanol, 2-ethylpentanol, 2-methylhexanol, 1-heptanol, 2-heptanol, 3-heptanol, 2-ethylhexanol, 1-octanol, 2-octanol, 1-nonanol, decanol, undecanol, dodecanol, and tridecanol.

Examples of the unsaturated aliphatic alcohol include alkenols and alkadienols, and specific examples thereof include 2-propylallyl alcohol, 2-methyl-4-pentenol, 1-hexenol, 2-ethyl-4-pentenol, 2-methyl-5-hexenol, 1-heptenol, 2-ethyl-5-hexenol, 1-octenol, 1-nonenol, undecenol, dodecenol, and geraniol.

Examples of the alicyclic alcohol include cycloalkanols and cycloalkenols, and specific examples thereof include methylcyclohexanol and α-terpineol.

Examples of the aromatic alcohol include phenethyl alcohol and salicyl alcohol.

Examples of the dihydric alcohol include triethylene glycol and 2-ethyl-1,3-hexanediol.

Examples of the acetate-based solvent include butyl carbitol acetate, and examples of the hydrocarbon-based solvent include decane, dodecane, tetradecane, and mixtures thereof.

[Resin]

The silver paste may further include a resin. Examples of the resin include an epoxy-based resin, a silicone-based resin, an acrylic resin, and mixtures thereof. Examples of the epoxy-based resin include a bisphenol A type epoxy resin, a novolac type epoxy resin, a cycloaliphatic epoxy resin, and mixtures thereof; examples of the silicone-based resin include a methylsilicone resin, an epoxy-modified silicone resin, a polyester-modified silicone resin, and mixtures thereof; and examples of the acrylic resin include an acrylate-based monomer resin. These resins are cured by heating the silver paste, and a cured body thereof fills the voids of a sintered body of the silver powder. As the voids of the sintered body of the silver powder are filled with a cured body of a thermosetting resin composition, the mechanical strength of the bonding layer is enhanced, and further, a decrease in the bonding strength under the load of cooling-heating cycle is suppressed. It is preferable that the content of the resin be within the range of 0.1% by mass to 3% by mass when the total amount of the silver paste is taken as 100% by mass. When the content of the resin is less than 0.1% by mass, there is a risk that the mechanical strength of the bonding layer may not be enhanced, and when the content is more than 3% by mass, there is a risk that sintering of the silver powder may be hindered while the mechanical strength of the bonding layer may be decreased. A more preferable content of the resin is within the range of 0.2% by mass to 2.5% by mass, and an even more preferable content is within the range of 0.3% by mass to 2.0% by mass.

[Method for producing silver paste]

A method for producing a silver paste having such a configuration will be described. First, a fatty acid silver salt, an aliphatic amine, and a solvent having a dielectric constant of less than 30 are prepared, the fatty acid silver salt, the aliphatic amine, and the solvent having a dielectric constant of less than 30 are mixed, and a mixture is prepared. When the total amount of this mixture is taken as 100% by mass, it is preferable to mix the fatty acid silver salt at a proportion of 0.1% by mass to 40% by mass, the aliphatic amine at a proportion of 0.1% by mass to 60% by mass, and the solvent having a dielectric constant of less than 30 at a proportion of 80% by mass or less. The mixing proportions of the fatty acid silver salt, the aliphatic amine, and the solvent having a dielectric constant of less than 30 are limited to be within the above-described ranges because precipitation and the like are less likely to occur in the mixed liquid. More preferred mixing proportions are 20% by mass to 30% by mass of the fatty acid silver salt, 20% by mass to 40% by mass of the aliphatic amine, and 40% by mass to 60% by mass of the solvent having a dielectric constant of less than 30, when the total amount of the fatty acid silver salt, the aliphatic amine, and the solvent having a dielectric constant of less than 30 is taken as 100% by mass.

Next, it is preferable that the mixture be heated to 30°C to 100°C and stirred for 5 minutes to 10 hours to prepare a mixed liquid. After being prepared, this mixed liquid is cooled by lowering the temperature to room temperature (25°C). As a result, a mixed solution of a fatty acid silver salt, an aliphatic amine, and a solvent having a dielectric constant of less than 30 (hereinafter, simply referred to as mixed solution) is prepared. The heating temperature and the heating time for the mixture are set to be within the above-described ranges in order to make it easy to uniformly mix the fatty acid silver salt, the aliphatic amine, and the solvent having a dielectric constant of less than 30. It is preferable that the heating temperature for the mixture be 40°C or higher and 80°C or lower. It is preferable that the heating time for the mixture be 10 minutes or more and 5 hours or less.

Next, after the mixed solution, the silver powder, and the high-dielectric-constant alcohol having a dielectric constant of 30 or more are mixed, the resulting mixture is stirred in a planetary stirrer or the like and is further kneaded by a three-roll mill or the like, and thereby a silver paste is obtained. When the silver paste is taken as 100% by mass, it is preferable that the content of the silver powder be set to be within the range of 50% by mass to 95% by mass, and it is preferable that the content of the high-dielectric-constant alcohol having a dielectric constant of 30 or more be set to be within the range of 0.01% by mass to 5% by mass. The balance is the mixed solution. It is more preferable that the content of the silver powder be set to be within the range of 80% by mass to 90% by mass and the content of the high-dielectric-constant alcohol having a dielectric constant of 30 or more is set to be within the range of 0.05% by mass to 3% by mass. In the silver paste, when the content of the silver powder is small, there is a risk that the viscosity of the silver paste may be lowered so that coating defects such as sagging may easily occur, and when the content is too high, there is a risk that the viscosity may increase so that the handleability may be deteriorated. The high-dielectric-constant alcohol having a dielectric constant of 30 or more is mixed together with the silver powder and the mixed solution because when the high-dielectric-constant alcohol having a dielectric constant of 30 or more is mixed together with the fatty acid silver salt, the aliphatic amine, and another solvent, the viscosity of the mixture increases, it is difficult for the silver powder to be mixed, the handleability of the prepared silver paste is deteriorated, and the pot life (available time) is shortened. By mixing the high-dielectric-constant alcohol having a dielectric constant of 30 or more , the effect of producing silver nanoparticles from the silver complex in the silver paste layer when the silver paste layer is heated is provided as described above. For the reasons described above, it is preferable that the content of the high-dielectric-constant alcohol having a dielectric constant of 30 or more be in the above-mentioned range. The silver paste may include the above-described resin. In this case, the cooling-heating cycle characteristics are enhanced. The resin may be added when mixing the mixed solution, the silver powder, and the high-dielectric-constant alcohol having a dielectric constant of 30 ore more. After mixing the mixed solution and the high-dielectric-constant alcohol having a dielectric constant or more are mixed, the silver powder may be added and mixed, and a silver paste may be obtained. Examples of the high-dielectric constant alcohol having a dielectric constant of 30 or more, in addition to the examples mentioned above for the first aspect of the invention, are propylene gylcol (dielectric constant 32) and polyethylene glycol (dielectric constant 30 ore more).

With regard to this mixed solution, it is preferable that the molar ratio of the aliphatic amine to the fatty acid silver salt, that is, the ratio of the molar amount of the aliphatic amine/molar amount of the fatty acid silver salt, be adjusted to be within the range of 1.5 to 3, and more preferably within the range of 1.7 to 2.8. When a silver paste is produced using such a mixed solution, the molar ratio of the aliphatic amine to the fatty acid silver salt in the mixed solution is the molar ratio of the aliphatic amine to the fatty acid silver salt in the silver paste.

[Method for producing bonded body]

A method for producing a bonded body by using the silver paste will be described.

In the production method of the present embodiment, a copper or copper alloy member and an electronic component are prepared. No metallized layer is formed on the surface of this copper or copper alloy member. Examples of the electronic component include semiconductor elements such as a semiconductor chip, a high-power LED element, and a power semiconductor element; and semiconductor packages. Examples of the copper or copper alloy member include a DBC substrate (copper-clad substrate) and a lead frame made of a copper alloy. However, the copper or copper alloy member is not limited to the DBC substrate and the lead frame. Next, the silver paste is applied directly on the surface of the copper or copper alloy member by, for example, a metal mask method or the like to form a silver paste layer having a desired planar shape. When the silver paste is heated, an oxide film of CuO and the like on the surface of the copper or copper alloy member is removed by the reducing action of the high-dielectric-constant alcohol included in the silver paste. Next, an electronic component is laminated on the copper or copper alloy member, with a silver paste layer interposed therebetween, and a laminated body is produced. Then, this laminated body is heated. For example, the laminated body is heated and retained for 10 minutes to 240 minutes (heating time) at a temperature of 120°C to 280°C (heating temperature). The atmosphere at this time is preferably a nitrogen atmosphere having an oxygen concentration of 500 ppm (volume basis) or less, and more preferably a nitrogen atmosphere having an oxygen concentration of 100 ppm (volume basis) or less. This is because the surface of the copper or copper alloy member is not oxidized. During heating, the silver in the complex formed by a reaction between the fatty acid silver salt and the aliphatic amine is reduced by the high-dielectric-constant alcohol to form silver nanoparticles. The silver powder (first silver particles, second silver particles, and third silver particles) in the silver paste layer is sintered together with these silver nanoparticles to form a bonding layer, and thus a bonded body in which the electronic component is bonded directly to the copper or copper alloy member, with this bonding layer interposed therebetween, is produced. The heating temperature and the heating time for the laminated body are limited to be within the above-described ranges, because when the heating time is less than 10 minutes, there is a risk that it may be difficult for sintering to proceed, and even when the heating time is more than 240 minutes, the cost increases without any change in the bonding characteristics. At the time of heating, the laminated body does not have to be subjected to pressurization in the lamination direction. This is because the pressurization step is omitted and the cost is reduced.

EXAMPLES

Next, Examples of the present invention will be described in detail together with Comparative Examples. First, mixed solutions 1 to 15 and mixed solutions 20 to 22, which are silver paste precursors that do not include silver powders, will be described, and next, Examples 1 to 21 and Comparative Examples 1 to 10 that used these mixed solutions will be described.

[Production Example for silver paste precursor (mixed solution)]

<Mixed solution 1>

First, silver acetate (fatty acid silver salt), aminodecane (aliphatic amine), and butyl carbitol acetate (solvent) were prepared, and when the total amount of the fatty acid silver salt, the aliphatic amine, and the solvent was taken as 100% by mass, 22% by mass of silver acetate (fatty acid silver salt), 41.3% by mass of aminodecane (aliphatic amine), and 36.7% by mass of butyl carbitol acetate (solvent) were measured, and these were introduced into a glass container together with a stirring bar of a stirrer. Then, the container was mounted on a hot plate that had been heated to 50°C, the mixture was stirred for one hour while the stirring bar of the stirrer was rotated at 300 rpm, and a mixed liquid was prepared. Next, the container storing the mixed liquid was removed from the hot plate, and the temperature of the mixed liquid was lowered to room temperature. As a result, a mixed solution 1 of a fatty acid silver salt and an aliphatic amine (hereinafter, simply referred to as a mixed solution), which is a silver paste precursor, was prepared.

<Mixed solutions 2 to 15 and mixed solutions 20 to 22>

Regarding mixed solutions 2 to 15 and mixed solutions 20 to 22, the compounds shown in Table 1 were used as the fatty acid silver salt, the aliphatic amine, and the solvent, and the fatty acid silver salt, the aliphatic amine, and the solvent were blended at each of the proportions shown in Table 1. Since mixed solution 20 did not include a fatty acid silver salt and mixed solution 21 did not include an aliphatic amine, those were not mixed solutions; however, in the present specification, for convenience, mixed solutions 20 and 21 will also be referred to as mixed solutions. In the column for the type of the fatty acid silver salt in Table 1 and Table 2, "A1" represents silver acetate, "A2" represents silver oxalate, and A3 " represents silver myristate. In the column for the type of the aliphatic amine in Table 1 and Table 2, "B1" represents aminodecane, "B2" represents hexylamine, "B3" represents octylamine, "B4" represents dodecylamine, and "B5" represents dioctylamine. In the column for the type of the solvent in Table 1 and Table 2, "C1" represents butyl carbitol acetate (dielectric constant: 7), "C2" represents terpineol (dielectric constant: 4), "C3" represents 2-ethyl1,3-hexanediol (dielectric constant: 19), "C4" represents 1-octanol (dielectric constant: 11), and "C5" represents 1,2,4-butanetriol (dielectric constant: 38, not according to the invention as a solvent).

[Table 1] (* not according to the invention)

| Type of mixed solution | Fatty acid silver salt | | Aliphatic amine | | Molar ratio (aliphatic amine/fatty acid silver salt) | Solvent | |
|---|---|---|---|---|---|---|---|
| | Type | Blending amount (mass%) | Type | Blending amount (mass%) | | Type | Blending amount (mass%) |
| Mixed solution 1 | A1 | 22.0 | B1 | 41.3 | 2 | C1 | 36.7 |
| Mixed solution 2 | A1 | 13.2 | B1 | 24.8 | 2 | C1 | 62.0 |
| Mixed solution 3 | A1 | 16.5 | B1 | 31.0 | 2 | C1 | 52.5 |
| Mixed solution 4 | A1 | 33.0 | B1 | 62.0 | 2 | C1 | 5.0 |
| Mixed solution 5 | A1 | 22.0 | B1 | 30.7 | 1.5 | C1 | 47.3 |
| Mixed solution 6 | A1 | 22.0 | B1 | 62.0 | 3 | C1 | 16.0 |
| Mixed solution 7 | A1 | 22.0 | B2 | 26.7 | 2 | C1 | 51.3 |
| Mixed solution 8 | A1 | 22.0 | B3 | 34.1 | 2 | C1 | 43.9 |
| Mixed solution 9 | A1 | 22.0 | B4 | 48.7 | 2 | C1 | 29.3 |
| Mixed solution 10 | A1 | 22.0 | B5 | 63.7 | 2 | C1 | 14.3 |
| Mixed solution 11 | A2 | 22.0 | B1 | 22.7 | 2 | C1 | 55.3 |
| Mixed solution 12 | A3 | 22.0 | B1 | 20.7 | 2 | C1 | 57.3 |
| Mixed solution 13 | A1 | 13.2 | B1 | 24.8 | 2 | C2 | 62.0 |
| Mixed solution 14 | A1 | 13.2 | B1 | 24.8 | 2 | C3 | 62.0 |
| Mixed solution 15 | A1 | 13.2 | B1 | 24.8 | 2 | C4 | 62.0 |
| Mixed solution 20* | None | 0 | B1 | 41.3 | - | C1 | 58.7 |
| Mixed solution 21 * | A1 | 22.0 | None | 0 | - | C1 | 78.0 |
| Mixed solution 22* | A1 | 13.2 | B1 | 24.8 | 2 | C5 | 62.0 |

| | | | | | |
|---|---|---|---|---|---|
| A1: | Silver acetate | B1: | Aminodecane | C1: | Butyl carbitol acetate (dielectric constant: 7) |
| A2: | Silver oxalate | B2: | Hexylamine | C2: | α-Terpineol (dielectric constant: 4) |
| A3: | Silver myristate | B3: | Oltylamine | C3: | 2-Ethyl-1,3-hexanediol (dielectric constant: 19) |
| | | B4: | Dodecylamine | C4: | 1-Octanol (dielectric constant: 11) |
| | | B5: | Dioctylamine | C5: | 1,2,4-Butanetriol (dielectric constant: 38)* |

<Comparison Test 1 and evaluation>

Each of the mixed solutions 1 to 15 and mixed solutions 20 to 22 was separately heated at 130°C for 10 minutes while being stirred, subsequently 1 g of each of these mixed solutions was dropped on a silicon wafer and dried under reduced pressure at a temperature of 25°C, and thereby a wafer having the dried matter attached to the surface was produced. Then, the surface of this wafer was observed with a SEM (scanning electron microscope), 1,000 particles attached to the surface were counted, projected areas of the extracted particles (primary particles) were measured using an image-processing software program (Image-J (National Institutes of Health: development)), the equivalent circle diameters were calculated from the obtained projected areas, and these were designated as primary particle sizes. The equivalent circle diameter was not measured for particles having a site where a contour could not be visually recognized.

The obtained primary particle sizes were converted into volume-based particle sizes, and the average value of the volume-based particle sizes was designated as average particle size of the dried matter. Furthermore, a sample in which silver powder was generated from the dried matter was considered to be "acceptable", and a sample in which silver powder was not generated from the dried matter, or a sample in which the silver powder could not be measured was considered to be "unacceptable". The average particle size of the dried matter and the determination results are presented in Table 2. Table 2 also shows the types of the fatty acid silver salt, the types of the aliphatic amine, and the types of the solvent.

[Table 2] (* not according to the invention)

| Type of mixed solution | Type of fatty acid silver salt | Type of aliphatic amine | Type of solvent | Average particle size of dried matter (nm) | Determination results |
|---|---|---|---|---|---|
| Mixed solution 1 | A1 | B1 | C1 | 60 | Acceptable |
| Mixed solution 2 | A1 | B1 | C1 | 60 | Acceptable |
| Mixed solution 3 | A1 | B1 | C1 | 60 | Acceptable |
| Mixed solution 4 | A1 | B1 | C1 | 60 | Acceptable |
| Mixed solution 5 | A1 | B1 | C1 | 70 | Acceptable |
| Mixed solution 6 | A1 | B1 | C1 | 40 | Acceptable |
| Mixed solution 7 | A1 | B2 | C1 | 100 | Acceptable |
| Mixed solution 8 | A1 | B3 | C1 | 70 | Acceptable |
| Mixed solution 9 | A1 | B4 | C1 | 40 | Acceptable |
| Mixed solution 10 | A1 | B5 | C1 | 40 | Acceptable |
| Mixed solution 11 | A2 | B1 | C1 | 60 | Acceptable |
| Mixed solution 12 | A3 | B1 | C1 | 50 | Acceptable |
| Mixed solution 13 | A1 | B1 | C2 | 40 | Acceptable |
| Mixed solution 14 | A1 | B1 | C3 | 50 | Acceptable |
| Mixed solution 15 | A1 | B1 | C4 | 50 | Acceptable |
| Mixed solution 20* | None | B1 | C1 | Not generated | Unacceptable |
| Mixed solution 21 * | A1 | None | C1 | Not measurable | Unacceptable |
| Mixed solution 22* | A1 | B1 | C5 | Not measurable | Unacceptable |

A1: Silver acetate  B1: Aminodecane  C1: Butyl carbitol acetate (dielectric constant: 7)
A2: Silver oxalate  B2: Hexylamine  C2: $\alpha$-Terpineol (dielectric constant: 4)
A3: Silver myristate  B3: Oltylamine  C3: 2-Ethyl-1,3-hexanediol (dielectric constant: 19)
 B4: Dodecylamine  C4: 1-Octanol (dielectric constant: 11)
 B5: Dioctylamine  C5: 1,2,4-Butanetriol (dielectric constant: 38)*

As is obvious from Table 2, since the mixed solution 20 did not include a fatty acid silver salt, that is, since the mixed solution 20 did not include silver that is expected to contribute to densification of the bonding layer, generation of silver powder was not observed during SEM (scanning electron microscope) observation, and the determination results were rated as unacceptable.

Since the mixed solution 21 did not include an aliphatic amine, a uniform mixed solution was not obtained, and since the dried matter on the silicon wafer formed lumps, silver powder could not be measured by SEM (scanning electron microscope) observation, and the determination results were rated as unacceptable. This is speculated to be because, since the mixed solution 21 did not include an aliphatic amine, decomposition of the fatty acid silver salt did not sufficiently proceed, and silver powder was not produced.

Since the mixed solution 22 used 1,2,4-butanetriol (dielectric constant: 38) having a dielectric constant of 30 or more as the solvent (not according to the invention), silver powder was excessively precipitated at the time of heating and stirring the mixed solution 22, and since the silver powder formed large aggregates when further dried under reduced pressure, the particle size of the silver powder could not be measured during SEM (scanning electron microscope) observation, and the determination results were rated as unacceptable.

In contrast to these, since the mixed solutions of the mixed solutions 1 to 15 included a fatty acid silver salt, an aliphatic amine, and a solvent having a dielectric constant of less than 30, generation of a silver powder having an average particle size of 50 nm to 100 nm was observed during SEM (scanning electron microscope) observation, and the determination results were rated as acceptable. This is speculated to be because since the mixed solutions 1 to 15 included a fatty acid silver salt and an aliphatic amine, the organic materials were rapidly decomposed by heating, and silver nanoparticles on which a highly active surface was exposed were easily formed.

[Production Example for silver paste]

First, a method for preparing a silver powder as a raw material for the silver pastes prepared in Examples 1 to 21 and Comparative Examples 1 to 10 will be described. These ten kinds of silver powder are shown under "No. 1 to No. 10" in Table 3 below. Table 3 also shows the organic material content in the ten kinds of silver powder.

[Table 3]

| | First silver particles Particle size 100 nm or more and less than 500 nm (vol%) | Second silver particles Particle size 50 nm or more and less than 100 nm (vol%) | Third silver particles Particle size less than 50 nm (vol%) | Content of organic material (mass%) |
|---|---|---|---|---|
| No.1 | 80 | 17.5 | 2.5 | 0.2 |
| No.2 | 60 | 39 | 1 | 0.3 |
| No.3 | 94 | 5 | 1 | 0.5 |
| No.4 | 80 | 19 | 1 | 0.5 |
| No.5 | 56 | 39 | 5 | 0.4 |
| No.6 | 93 | 5 | 2 | 0.5 |
| No.7 | 94 | 1 | 5 | 0.5 |
| No.8 | 40 | 50 | 10 | 0.5 |
| No.9 | 60 | 33 | 7 | 0.2 |
| No.10 | 100 | 0 | 0 | 0.3 |

The silver powder (mixture/aggregates of first, second, and third silver particles) of No. 1 shown in Table 3 was prepared as follows. First, fine silver particles (raw material powder A) in which the D10, D50, and D90 were 20 nm, 50 nm, and 100 nm, respectively, and fine silver particles (raw material powder B) in which the D10, D50, and D90 were 150 nm, 300 nm, and 500 nm, respectively, were prepared. The method for preparing the fine silver particles (raw material powder A) and the fine silver particles (raw material powder B) will be described later. The D10, D50, and D90 of each kind of the fine silver particles were determined from a particle size distribution curve of the fine silver particles. The particle size distribution curve of the fine silver particles was measured by a dynamic light scattering method that will be described below. For silver powder No. 1, raw material powder A and raw material powder B were mixed at proportions that gave a mass ratio of 1:3 to obtain a fine silver particle mixture.

Next, this fine silver particle mixture, sodium ascorbate (organic reducing agent), and water were mixed at proportions that gave a mass ratio of 10:1:89, and a fine silver particle slurry was prepared. This fine silver particle slurry was heated at a temperature of 90°C for 3 hours, and thus the fine silver particles were subjected to a reduction treatment. Next, the fine silver particle slurry was allowed to cool naturally to room temperature, and then solid matter was separated and collected by using a centrifuge. This collected solid matter (water-containing fine silver particle aggregates) was washed with water several times and dried to obtain silver powder No. 1 (mixture/aggregates of first, second, and third silver particles) as shown in Table 3.

The silver powder of No. 2 was obtained in the same manner as in the above-described preparation method for the silver powder of No. 1, except that the mixing proportions of the fine silver particles (raw material powder A) and the fine silver particles (raw material powder B) were set to 1: 1 as a mass ratio.

The silver powder of No. 3 was obtained in the same manner as in the above-described preparation method for the silver powder of No. 1, except that the mixing proportions of the fine silver particles (raw material powder A) and the fine silver particles (raw material powder B) were set to 1:5 as a mass ratio.

The silver powder of No. 4 was obtained by the following method. To 1200 g of ion-exchanged water maintained at 50°C, 900 g of an aqueous solution of silver nitrate maintained at 50°C and 600 g of an aqueous solution of sodium citrate maintained at 50°C were simultaneously added dropwise for 5 minutes, and a silver citrate slurry was prepared. The ion-exchanged water was continuously stirred while the aqueous solution of silver nitrate and the aqueous solution of sodium citrate were simultaneously added dropwise to the ion-exchanged water. The concentration of silver nitrate in the aqueous solution of silver nitrate was 66% by mass, and the concentration of citric acid in the aqueous solution of sodium citrate was 56% by mass. Next, to the silver citrate slurry maintained at 50°C, 300 g of an aqueous solution of sodium formate maintained at 50°C was added dropwise over 30 minutes to obtain a mixed slurry. The concentration of formic acid in this aqueous solution of sodium formate was 58% by mass. Next, the mixed slurry was subjected to a predetermined heat treatment. Specifically, the mixed slurry was heated to a maximum temperature of 60°C at a rate of temperature increase of 10°C/hour and maintained at 60°C (maximum temperature) for 30 minutes, and then the temperature was lowered to 20°C over 60 minutes. As a result, a silver powder slurry was obtained. The silver powder slurry was introduced into a centrifuge and was rotated for 10 minutes at a speed of rotation of 1000 rpm. As a result, the liquid layer in the silver powder slurry was removed, and a dehydrated and desalted silver powder slurry was obtained. This dehydrated and desalted silver powder slurry was dried by a freeze-drying method for 30 hours to obtain a silver powder of No. 4 having a particle size distribution of volume-based particle sizes as shown in Table 3.

The silver powder of No. 5 was obtained in the same manner as in the above-described preparation method for the silver powder of No. 1, except that the mixing proportions of the fine silver particles (raw material powder A) and the fine silver particles (raw material powder B) were set to 2:1 as a mass ratio.

The silver powder of No. 6 was obtained in the same manner as in the above-described preparation method for the silver powder of No. 1, except that the mixing proportions of the fine silver particles (raw material powder A) and the fine silver particles (raw material powder B) were set to 1:6 as a mass ratio.

The silver powder of No. 7 was obtained in the same manner as in the above-described preparation method for the silver powder of No. 1, except that the mixing proportions of the fine silver particles (raw material powder A) and the fine silver particles (raw material powder B) were set to 2:9 as a mass ratio.

The silver powder of No. 8 was obtained in the same manner as in the above-described preparation method for the silver powder of No. 1, except that only the fine silver particles (raw material powder A) were used without mixing the fine silver particles (raw material powder A) and the fine silver particles (raw material powder B).

The silver powder of No. 9 was obtained in the same manner as in the above-described preparation method for the silver powder of No. 1, except that the mixing proportions of the fine silver particles (raw material powder A) and the fine silver particles (raw material powder B) were set to 4:3 as a mass ratio.

The silver powder of No. 10 was obtained in the same manner as in the above-described preparation method for the silver powder of No. 1, except that the mixing proportions of the fine silver particles (raw material powder A) and the fine silver particles (raw material powder B) were set to 1:9 as a mass ratio.

Regarding the silver powder (raw material powder A), silver nitrate, citric acid, and potassium hydroxide were mixed in distilled water at an equimolar ratio (1: 1: 1) with respect to silver ions in silver nitrate, to produce a suspension. Hydrazine acetate was added to this suspension at a molar ratio of 2 to 1 of silver ions. The silver powder (raw material powder A) was obtained by causing the suspension, to which hydrazine acetate had been added, to react at a liquid temperature of 40°C, and subjecting the obtained reaction liquid slurry to washing, collecting, and drying.

Fine silver particles (raw material powder B) were obtained by mixing an aqueous solution of silver nitrate, aqueous ammonia, and distilled water, preparing an aqueous solution of silver ammine having a silver concentration of 22 g/L, adding a reducing solution to this aqueous solution of silver amine, and subjecting a silver particle slurry thus produced to washing, collecting, and drying. The reducing solution is a mixed liquid of an aqueous solution of hydroquinone and an aqueous solution of sodium hydroxide, and is a liquid in which the oxidation-reduction potential has been adjusted to -380 mV based on Ag/AgCl.

<Method for measuring particle size distribution of silver particles>

Five hundred images of aggregates (secondary particles) in which first, second, and third silver particles were aggregated were acquired by using SEM, and the particle sizes of the silver particles (primary particles) included in each silver particle aggregate were measured. At this time, the apparatus magnification for SEM was set to 100000 times. From the five hundred SEM images of silver particle aggregates, silver particles from which the entire contour of a silver particle (primary particle) could be visually recognized were extracted. Next, projected areas of the extracted silver particles were measured using an image-processing software program (Image-J), equivalent circle diameters were calculated from the obtained projected areas, and these were designated as the particle sizes of the silver particles. The equivalent circle diameter was not measured for silver particles having a site where the contour could not be visually recognized. The particle sizes of the obtained silver particles were converted into volume-based particle sizes, and a particle size distribution of the volume-based particle sizes was determined. The results are presented in Table 3.

<Method for measuring content of organic material>

The contents of organic materials in the silver powders of No. 1 to No. 10 were calculated by the following method. The silver powder before mixing with the mixed solution was measured and heated in air at a temperature of 150°C for 30 minutes. After heating, the silver powder was allowed to cool naturally to room temperature, and the mass of the silver powder was measured. The content of an organic material was calculated from the following Formula (1). As a result, the content of the organic material in the silver powder of No. 1 was 0.2% by mass.

$$\text{Content of organic material (mass\%)} = \{(A - B) / A\} \times 100 \dots \quad (1)$$

However, A in Formula (1) represents the mass of the silver powder before heating, and B represents the mass of the silver powder after heating. The obtained results are presented in Table 3.

Next, Examples 1 to 26 and Comparative Examples 1 to 10 for preparing silver pastes will be described.

<Example 1>

In order to adjust the amount of the silver paste to 100% by mass, mixed solution 1 (24.00% by mass), the silver powder of No. 1 (75.00% by mass), and 1,2,4-butanetriol (D1) (1.00% by mass) as a high-dielectric-constant alcohol were mixed and then stirred in a planetary stirrer, and the mixture was further kneaded with a three-roll mill. As a result, a silver paste was obtained. This silver paste was designated as Example 1.

<Examples 2 to 21 and Comparative Examples 1 to 10>

Regarding 31 kinds of silver pastes of Examples 2 to 21 and Comparative Examples 1 to 10, each mixed solution was prepared by using the fatty acid silver salt, the aliphatic amine, and the solvent shown in Table 1 and Table 2, and at the same time, the silver powder, the mixed solution, and the high-dielectric-constant alcohol were blended at the proportions shown in Table 4 and Table 5. The silver pastes were prepared in the same manner as in Example 1, except that the silver powder, the mixed solution, and the high-dielectric-constant alcohol shown in Table 4 and Table 5 were blended. However, Comparative Examples 2 and 4 did not form pastes for reasons described later. In Examples 5, 6, 11, 12, 18, and 19, two kinds of high-dielectric-constant alcohols were used.

The mixed solutions used in Examples 1 to 21 and Comparative Examples 1 to 10 are indicated as either "Mixed solutions 1 to 15" or "Mixed solutions 20 to 22" in the column for the type of the mixed solution in Table 4 and Table 5. In Examples 1 to 21 and Comparative Examples 1 to 10, any one of ten kinds (No. 1 to No. 10) of silver powders having different particle size distributions as shown in Table 3 was blended in. The silver powders used in Examples 1 to 21 and Comparative Examples 1 to 10 are indicated by any of "No. 1 to No. 10" in the column for the type of the silver powder in Table 4 and Table 5. In the column for the type of the high-dielectric-constant alcohol in Table 4 and Table 5, "D1" represents 1,2,4-butanetriol (dielectric constant: 38), "D2" represents 1,3-propanediol (dielectric constant: 36), "D3" is glycerin (dielectric constant: 44), "D4" represents diethylene glycol (dielectric constant: 34), and "D5" represents 2-methoxyethanol (dielectric constant: 18, not according to the invention as a high-dielectric-constant alcohol).

<Comparison Test 2 and evaluation>

(1) Bonded bodies were each produced using the silver pastes of Examples 1 to 21 and Comparative Examples 1, 3, and 5 to 10. Specifically, first, a Si wafer (thickness: 200 μm) that measured 10 mm on each side and was provided with gold plating on the surface, the Si wafer imitating an electronic component, was prepared. An oxygen-free copper plate (thickness: 1 mm) that measured 20 mm on each side was prepared as a copper or copper alloy member. No metallized layer was formed on the surface of this copper plate. Next, the above-described silver paste was applied on the surface of the oxygen-free copper plate by a metal mask method, and thus a silver paste layer was formed. Next, the Si wafer was loaded on the silver paste layer, and thereby a laminated body was produced. This laminated body was heated by maintaining the laminated body at a temperature of 250°C for 60 minutes in a nitrogen atmosphere having an oxygen concentration of 100 ppm (volume basis), and then a Si wafer was bonded to the oxygen-free copper plate, with the bonding layer interposed therebetween. These bonded bodies were used as the bonded bodies of Examples 1 to 21 and Comparative Examples 1, 3, and 5 to 10. The laminated bodies were not pressurized in the lamination direction. The bonding strength of these bonded bodies was measured as follows.

(Method for measuring bonding strength of bonded body)

The bonding strength of the 29 kinds of bonded bodies of Examples 1 to 21 and Comparative Examples 1, 3, and 5 to 10 was measured using a shear strength evaluation tester. Specifically, the measurement of the bonding strength was performed by horizontally fixing the oxygen-free copper plate of the bonded body, pressing the Si wafer of the bonded body from the side in the horizontal direction by means of a shear tool at a position 50 μm above the surface (top face) of the bonding layer, and then measuring the strength at the time when the Si wafer was fractured. The moving speed of the shear tool was set to 0.1 mm/sec. The strength test was performed three times per one condition, and the arithmetic mean value of those was used as the measured value of the bonding strength.

(2) Calcined silver films were produced using the 29 kinds of silver pastes of Examples 1 to 21 and Comparative Examples 1, 3, and 5 to 10. Specifically, first, each of the 29 kinds of silver pastes was applied on a transparent glass plate using a metal mask plate (hole size: 10 mm in length × 10 mm in width, thickness: 50 μm) to form a silver paste layer. Next, the silver paste layer formed on the transparent glass substrate was maintained at a temperature of 250°C (heating temperature) for 60 minutes (heating time) in a nitrogen atmosphere having an oxygen concentration of 100 ppm (volume basis) to form a calcined silver film. These calcined silver films were designated as calcined silver films of Examples 1 to 21 and Comparative Examples 1, 3, and 5 to 10. The thermal diffusivities of these calcined silver films were measured as follows.

(Method for measuring thermal diffusivity of calcined silver film)

For the 29 kinds of calcined silver films of Examples 1 to 21 and Comparative Examples 1, 3, and 5 to 10, the thermal diffusivity was measured by a laser flash method. Specifically, first, the temperature change T(t) on the back surface of a calcined silver film, when the calcined silver film is heated instantaneously by uniformly irradiating the front surface of the calcined silver film with pulsed laser light, was measured.

Next, since the temperature change T(t) on the back surface of the calcined silver film is represented by a one-dimensional heat conduction equation, a (T(t) - t) curve was obtained by plotting the temperature change T(t) on the back surface of the calcined silver film on the axis of ordinate and plotting the elapsed time t on the axis of abscissa, and the time $t_{0.5}$ required to reach a temperature equivalent to half the maximum flash temperature $T_{MAX}$ was determined from this curve. Then, the thermal diffusivity α of the calcined silver film was determined by the following Formula (2).

$$\alpha = 1.370 \times L^2 / (\pi^2 \times t_{0.5}) \quad \ldots\ldots \quad (2)$$

In the above-described Formula (2), L represents the thickness of the calcined silver film. The results of the thermal diffusivity of these calcined silver films are shown in Table 4 and Table 5.

[Table 4]

| | | Silver powder | | Mixed solution | | High-dielectric constant alcohol | | Bonding strength of bonded body (MPa) | Thermal diffusivity of calcined silver film (W/mK) |
|---|---|---|---|---|---|---|---|---|---|
| | | Blending proportion (mass%) | Type | Type | Blending proportion (mass%) | Type | Blending proportion (mass%) | | |
| Example 1 | | 75.00 | No.1 | Mixed solution 1 | 24.00 | D1 | 1.00 | 39 | 125 |
| Example 2 | | 80.00 | No.1 | Mixed solution 1 | 19.00 | D2 | 1.00 | 42 | 151 |
| Example 3 | | 85.00 | No.1 | Mixed solution 1 | 14.90 | D3 | 0.10 | 54 | 155 |
| Example 4 | | 90.00 | No.1 | Mixed solution 1 | 9.90 | D4 | 0.10 | 48 | 153 |

(continued)

| | | Silver powder | | Mixed solution | | High-dielectric constant alcohol | | Bonding strength of bonded body (MPa) | Thermal diffusivity of calcined silver film (W/mK) |
|---|---|---|---|---|---|---|---|---|---|
| | | Blending proportion (mass%) | Type | Type | Blending proportion (mass%) | Type | Blending proportion (mass%) | | |
| Example 5 | | 85.00 | No.2 | Mixed solution 1 | 13.00 | D1<br>D2 | 1.00<br>1.00 | 44 | 139 |
| Example 6 | | 85.00 | No.3 | Mixed solution 1 | 14.00 | D3<br>D4 | 0.05<br>0.95 | 39 | 158 |
| Example 7 | | 85.00 | No.4 | Mixed solution 1 | 13.00 | D1 | 2.00 | 47 | 148 |
| Example 8 | | 85.00 | No.1 | Mixed solution 5 | 13.00 | D2 | 2.00 | 48 | 145 |
| Example 9 | | 85.00 | No.1 | Mixed solution 6 | 13.00 | D3 | 2.00 | 53 | 155 |
| Example 10 | | 85.00 | No.1 | Mixed solution 7 | 13.00 | D4 | 2.00 | 46 | 153 |
| Example 11 | | 85.00 | No.1 | Mixed solution 8 | 13.00 | D1<br>D2 | 1.00<br>1.00 | 50 | 154 |
| Example 12 | | 85.00 | No.1 | Mixed solution 9 | 14.00 | D3<br>D4 | 0.05<br>0.95 | 43 | 158 |
| Example 13 | | 85.00 | No.1 | Mixed solution 10 | 14.95 | D1 | 0.05 | 35 | 130 |
| Example 14 | | 85.00 | No.1 | Mixed solution 11 | 12.00 | D1 | 3.00 | 40 | 154 |
| Example 15 | | 85.00 | No.1 | Mixed solution 12 | 10.00 | D1 | 5.00 | 49 | 153 |
| Example 16 | | 85.00 | No.5 | Mixed solution 1 | 14.00 | D1 | 1.00 | 41 | 138 |
| Example 17 | | 85.00 | No.6 | Mixed solution 1 | 14.00 | D1 | 1.00 | 45 | 133 |
| Example 18 | | 85.00 | No.1 | Mixed solution 13 | 13.00 | D1<br>D2 | 1.00<br>1.00 | 51 | 143 |
| Example 19 | | 85.00 | No.1 | Mixed solution 14 | 14.00 | D3<br>D4 | 0.05<br>0.95 | 45 | 156 |

(continued)

| | Silver powder | | Mixed solution | | High-dielectric constant alcohol | | Bonding strength of bonded body (MPa) | Thermal diffusivity of calcined silver film (W/mK) |
|---|---|---|---|---|---|---|---|---|
| | Blending proportion (mass%) | Type | Type | Blending proportion (mass%) | Type | Blending proportion (mass%) | | |
| Example 20 | 85.00 | No.1 | Mixed solution 15 | 14.00 | D1 | 1.00 | 43 | 152 |
| Example 21 | 85.00 | No.1 | Mixed solution 1 | 14.99 | D1 | 0.01 | 35 | 100 |

[Table 5] (* not according to the invention)

| | Silver powder | | Mixed solution | | High-dielectric constant alcohol | | Bonding strength of bonded body (MPa) | Thermal diffusivity of calcined silver film (W/mK) |
|---|---|---|---|---|---|---|---|---|
| | Blending proportion (mass%) | Type | Type | Blending proportion (mass%) | Type | Blending proportion (mass%) | | |
| Comparative Example 1 | 85.00 | No.1 | Mixed solution 20 | 15.00 | None | 0 | 10 | 39 |
| Comparative Example 2 | 85.00 | No.1 | Mixed solution 21 | 15.00 | None | 0 | Not forming paste | |
| Comparative Example 3 | 85.00 | No.1 | Mixed solution 20 | 14.00 | D1 | 1.00 | 9 | 38 |
| Comparative Example 4 | 85.00 | No.1 | Mixed solution 21 | 14.00 | D1 | 1.00 | Not forming paste | |
| Comparative Example 5 | 85.00 | No.7 | Mixed solution 1 | 15.00 | None | 0 | 10 | 58 |
| Comparative Example 6 | 85.00 | No.8 | Mixed solution 1 | 15.00 | None | 0 | 5 | 40 |
| Comparative Example 7 | 85.00 | No.9 | Mixed solution 1 | 15.00 | None | 0 | 5 | 45 |
| Comparative Example 8 | 85.00 | No.10 | Mixed solution 1 | 15.00 | None | 0 | 6 | 70 |
| Comparative Example 9 | 85.00 | No.1 | Mixed solution 1 | 15.00 | None | 0 | 25 | 75 |

(continued)

|  | Silver powder | | Mixed solution | | High-dielectric constant alcohol | | Bonding strength of bonded body (MPa) | Thermal diffusivity of calcined silver film (W/mK) |
|---|---|---|---|---|---|---|---|---|
|  | Blending proportion (mass%) | Type | Type | Blending proportion (mass%) | Type | Blending proportion (mass%) | | |
| Comparative Example 10 | 85.00 | No.1 | Mixed solution 1 | 12.00 | D5* | 3.00 | 27 | 77 |

D1: 1,2,4-Butanetriol (dielectric constant: 38)
D2: 1,3-Propanediol (dielectric constant: 36)
D3: Glycerin (dielectric constant: 44)
D4: Diethylene glycol (dielectric constant: 34)
D5: 2-Methoxyethanol (dielectric constant: 18)*

As is clear from Table 5, in Comparative Example 1, since a bonded body and a calcined silver film were produced using a silver paste that included the mixed solution 20 (15.00% by mass), to which no fatty acid silver salt was added, and did not include a high-dielectric-constant alcohol, due to the fact that a high-dielectric-constant alcohol was not included as well as the fact that the mixed solution 20 did not include a fatty acid silver salt, the bonding strength of the bonded body was as small as 10 MPa, and the thermal diffusivity of the calcined silver film was as small as 39 W/mK.

In Comparative Example 2, an attempt was made to produce a bonded body and a calcined silver film by using a silver paste that included the mixed solution 21 (15.00% by mass), to which no aliphatic amine was added, but did not include a high-dielectric-constant alcohol; however, since a silver paste was not formed due to the fact that the mixed solution did not include an aliphatic amine, a bonded body and a calcined silver film could not be produced.

In Comparative Example 3, since a bonded body and a calcined silver film were produced using a silver paste that included the mixed solution 20 (14.00% by mass), to which no fatty acid silver salt was added, and included 1,2,4-butanetriol (1.00% by mass), due to the fact that the mixed solution 20 did not include a fatty acid silver salt, even when 1,2,4-butanetriol (D1) having a dielectric constant of 38 (high-dielectric-constant alcohol) was used, the bonding strength of the bonded body was as small as 9 MPa, and the thermal diffusivity of the calcined silver film was as small as 38 W/mK.

In Comparative Example 4, an attempt was made to produce a bonded body and a calcined silver film by using a silver paste that included the mixed solution 21 (14.00% by mass), to which no aliphatic amine was added, and included 1,2,4-butanetriol (D1) (1.00% by mass) as a high-dielectric-constant alcohol; however, since a silver paste was not formed due to the fact that the mixed solution 21 did not include an aliphatic amine, a bonded body and a calcined silver film could not be produced.

In Comparative Example 5, since a bonded body and a calcined silver film were produced using a silver paste that included the mixed solution 1 (15.00% by mass), to which a fatty acid silver salt and an aliphatic amine were added, but did not include a high-dielectric-constant alcohol, due to the fact that a high-dielectric-constant alcohol was not included, the bonding strength of the bonded body was as small as 10 MPa, and the thermal diffusivity of the calcined silver film was as small as 58 W/mK.

In Comparative Example 6, since a bonded body and a calcined silver film were produced using a silver paste that included the mixed solution 1 (15.00% by mass), to which a fatty acid silver salt and an aliphatic amine were added, and included the silver powder of No. 8 (85.00% by mass) but did not include a high-dielectric-constant alcohol, due to the fact that a dielectric-constant alcohol was not included, the bonding strength of the bonded body was as small as 5 MPa, and the thermal diffusivity of the calcined silver film was as small as 40 W/mK.

In Comparative Example 7, since a bonded body and a calcined silver film were produced using a silver paste that included the mixed solution 1 (15.00% by mass), to which a fatty acid silver salt and an aliphatic amine were added, and included the silver powder of No. 9 (85.00% by mass) but did not include a high-dielectric-constant alcohol, due to the fact that a dielectric-constant alcohol was not included, the bonding strength of the bonded body was as small as 5 MPa, and the thermal diffusivity of the calcined silver film was as small as 45 W/mK.

In Comparative Example 8, since a bonded body and a calcined silver film were produced using a silver paste that included the mixed solution 1 (15.00% by mass), to which a fatty acid silver salt and an aliphatic amine were added, and included the silver powder of No. 10 (85.00% by mass) but did not include a high-dielectric-constant alcohol, due to the fact that a dielectric-constant alcohol was not included, the bonding strength of the bonded body was as small as 6 MPa, and the thermal diffusivity of the calcined silver film was as small as 70 W/mK.

In Comparative Example 9, since a bonded body and a calcined silver film were produced using a silver paste that included the mixed solution 1 (15.00% by mass), to which a fatty acid silver salt and an aliphatic amine were added, but did not include a high-dielectric-constant alcohol, due to the fact that a dielectric-constant alcohol was not included, the bonding strength of the bonded body was as small as 25 MPa, and the thermal diffusivity of the calcined silver film was as small as 75 W/mK.

In Comparative Example 10, since a bonded body and a calcined silver film were produced using a silver paste that included the mixed solution 1 (12.00% by mass), to which a fatty acid silver salt and an aliphatic amine were added, and included 2-methoxyethanol (D5) (3.00% by mass), due to the fact that 2-methoxyethanol has a low dielectric constant such as 18, the bonding strength of the bonded body was as small as 27 MPa, and the thermal diffusivity of the calcined silver film was as small as 77 W/mK.

In contrast to these Comparative Examples 1, 3, and 5 to 10, in Examples 1 to 21, bonded bodies and calcined silver films were produced using silver pastes by preparing and kneading the mixed solutions 1 to 15 that included a fatty acid silver salt, an aliphatic amine and a solvent (provided that the dielectric constant was less than 30) with a high-dielectric-constant alcohol having a dielectric constant of 34 or more and 44 or less. Therefore, in Examples 1 to 21, the bonding strength of the bonded bodies was as large as 35 MPa to 54 MPa, and the thermal diffusivity of the calcined silver films was as large as 100 W/mK to 158 W/mK.

INDUSTRIAL APPLICABILITY

The silver paste of the present invention can be utilized for bonding layers that bond semiconductor elements such as high-power LED elements and power semiconductor elements, and electronic components such as semiconductor packages to copper or copper alloy members, which are substrates such as DBC substrates (copper-clad substrates) and lead frames.

**Claims**

1. A silver paste comprising:

    a silver powder;
    a fatty acid silver salt;
    an aliphatic amine;
    a high-dielectric-constant alcohol having a dielectric constant of 34 or more and 44 or less; and
    a solvent having a dielectric constant of less than 30,
    wherein the dielectric constant is a value measured at 22°C using a dielectric constant meter for liquids.

2. The silver paste according to Claim 1,
    wherein the high-dielectric-constant alcohol is included in the silver paste at a proportion of 0.01% by mass to 5% by mass when an amount of the silver paste is taken as 100% by mass.

3. The silver paste according to Claim 1 or 2,
    wherein the silver powder comprises:

    first silver particles having a particle size of 100 nm or more and less than 500 nm as determined by SEM in a range of 55% by volume or more and 95% by volume or less;
    second silver particles having a particle size of 50 nm or more and less than 100 nm as determined by SEM in a range of 5% by volume or more and 40% by volume or less; and
    third silver particles having a particle size of less than 50 nm as determined by SEM in a range of 5% by volume or less.

4. A method for producing a silver paste, the method comprising the steps of:

    mixing a fatty acid silver salt, an aliphatic amine, and a solvent having a dielectric constant of less than 30 to obtain a mixture;
    obtaining a mixed solution by cooling the mixture that is stirred while being heated; and
    kneading the mixed solution, a silver powder, and a high-dielectric-constant alcohol having a dielectric constant of 34 or more and 44 or less to obtain a silver paste,
    wherein the dielectric constant is a value measured at 22°C using a dielectric constant meter for liquids.

5. A method for producing a bonded body, the method comprising the steps of:

forming a silver paste layer by applying the silver paste according to any one of Claims 1 to 3 directly on a surface of a copper or copper alloy member;

producing a laminated body by laminating an electronic component on the silver paste layer; and

producing a bonded body, in which the copper or copper alloy member is bonded to the electronic component through a bonding layer, by forming the bonding layer by sintering the silver powder in the silver paste by heating the laminated body.

**Patentansprüche**

1. Eine Silberpaste, umfassend:

ein Silberpulver;

ein Silbersalz einer Fettsäure;

ein aliphatisches Amin;

einen Alkohol mit hoher Dielektrizitätskonstante mit einer Dielektrizitätskonstante von 34 oder mehr und 44 oder weniger; und

ein Lösungsmittel mit einer Dielektrizitätskonstante von weniger als 30,

wobei die Dielektrizitätskonstante ein bei 22°C mit einem Dielektrizitätskonstantenmesser für Flüssigkeiten gemessener Wert ist.

2. Die Silberpaste nach Anspruch 1,

wobei der Alkohol mit hoher Dielektrizitätskonstante in der Silberpaste in einem Anteil von 0,01 Massenprozent bis 5 Massenprozent enthalten ist, wenn die Menge der Silberpaste als 100 Massenprozent angenommen wird.

3. Die Silberpaste nach Anspruch 1 oder 2,

wobei das Silberpulver umfasst:

erste Silberteilchen mit einer Teilchengröße von 100 nm oder mehr und weniger als 500 nm, bestimmt durch SEM, in einem Bereich von 55 Volumenprozent oder mehr und 95 Volumenprozent oder weniger;

zweite Silberteilchen mit einer Teilchengröße von 50 nm oder mehr und weniger als 100 nm, bestimmt durch SEM, in einem Bereich von 5 Volumenprozent oder mehr und 40 Volumenprozent oder weniger; und

dritte Silberteilchen mit einer Teilchengröße von weniger als 50 nm, bestimmt durch SEM, in einem Bereich von 5 Volumenprozent oder weniger.

4. Verfahren zur Herstellung einer Silberpaste, wobei das Verfahren die folgenden Schritte umfasst:

Mischen eines Fettsäuresilbersalzes, eines aliphatischen Amins und eines Lösungsmittels mit einer Dielektrizitätskonstante von weniger als 30, um eine Mischung zu erhalten;

Gewinnung einer gemischten Lösung durch Abkühlen des unter Rühren erwärmten Gemischs; und

Kneten der gemischten Lösung, eines Silberpulvers und eines Alkohols mit hoher Dielektrizitätskonstante mit einer Dielektrizitätskonstante von 34 oder mehr und 44 oder weniger, um eine Silberpaste zu erhalten,

wobei die Dielektrizitätskonstante ein bei 22°C mit einem Dielektrizitätskonstantenmesser für Flüssigkeiten gemessener Wert ist.

5. Verfahren zur Herstellung eines Verbundkörpers, wobei das Verfahren die folgenden Schritte umfasst:

Bilden einer Silberpastenschicht durch Auftragen der Silberpaste nach einem der Ansprüche 1 bis 3 direkt auf eine Oberfläche eines Elements aus Kupfer oder einer Kupferlegierung;

Herstellung eines laminierten Körpers durch Laminieren eines elektronischen Bauteils auf die Silberpastenschicht; und

Herstellen eines Verbundkörpers, in dem das Kupfer- oder Kupferlegierungselement durch eine Verbindungsschicht mit dem elektronischen Bauteil verbunden ist, durch Bilden der Verbindungsschicht durch Sintern des Silberpulvers in der Silberpaste durch Erhitzen des laminierten Körpers.

**Revendications**

1. Pâte d'argent comprenant

   une poudre d'argent;
   un sel d'argent d'acide gras;
   une amine aliphatique;
   un alcool à haute constante diélectrique ayant une constante diélectrique de 34 ou plus et de 44 ou moins; et
   un solvant dont la constante diélectrique est inférieure à 30,
   où la constante diélectrique est une valeur mesurée à 22°C à l'aide d'un appareil de mesure de la constante diélectrique des liquides.

2. Pâte d'argent selon la revendication 1,
   dans lequel l'alcool à haute constante diélectrique est inclus dans la pâte d'argent dans une proportion de 0,01 % en masse à 5 % en masse lorsque la quantité de pâte d'argent est considérée comme étant de 100 % en masse.

3. Pâte d'argent selon la revendication 1 ou 2,
   dans lequel la poudre d'argent comprend:

   des premières particules d'argent ayant une taille de 100 nm ou plus et inférieure à 500 nm, déterminée par MEB, dans une fourchette de 55 % en volume ou plus et de 95 % en volume ou moins;
   des secondes particules d'argent ayant une taille de 50 nm ou plus et de moins de 100 nm, déterminée par MEB, dans une fourchette de 5 % en volume ou plus et de 40 % en volume ou moins; et
   troisièmement, des particules d'argent dont la taille est inférieure à 50 nm, telle que déterminée par MEB, dans une fourchette de 5 % en volume ou moins.

4. Méthode de production d'une pâte d'argent, comprenant les étapes suivantes:

   mélanger un sel d'argent d'acide gras, une amine aliphatique et un solvant dont la constante diélectrique est inférieure à 30 pour obtenir un mélange;
   obtenir une solution mixte en refroidissant le mélange qui est agité tout en étant chauffé; et
   malaxer la solution mélangée, une poudre d'argent et un alcool à haute constante diélectrique ayant une constante diélectrique de 34 ou plus et de 44 ou moins pour obtenir une pâte d'argent,
   où la constante diélectrique est une valeur mesurée à 22°C à l'aide d'un appareil de mesure de la constante diélectrique des liquides.

5. Méthode de production d'un corps collé, comprenant les étapes suivantes :

   former une couche de pâte d'argent en appliquant la pâte d'argent selon l'une des revendications 1 à 3 directement sur une surface d'un élément en cuivre ou en alliage de cuivre;
   produire un corps stratifié en stratifiant un composant électronique sur la couche de pâte d'argent; et
   produire un corps lié, dans lequel l'élément en cuivre ou en alliage de cuivre est lié au composant électronique par une couche de liaison, en formant la couche de liaison par frittage de la poudre d'argent dans la pâte d'argent en chauffant le corps stratifié.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5872545 B
- WO 2012133767 A1
- JP 6329703 B